# EUROPEAN PATENT SPECIFICATION

(11) **EP 2 156 562 B1**
(45) Date of publication and mention of the grant of the patent: **11.07.2012**
(21) Application number: 08763118.0
(22) Date of filing: 27.05.2008
(51) Int. Cl.: H03M 1/06, H03M 1/12

(54) **ERROR PROCESSING IN TIME INTERLEAVED SIGNAL PROCESSING DEVICES**
FEHLERVERARBEITUNG IN SIGNALVERARBEITUNGSVORRICHTUNGEN MIT ZEITVERSCHACHTELUNG
TRAITEMENT D'ERREUR DANS DES DISPOSITIFS DE TRAITEMENT DE SIGNAUX À ENTRELACEMENT TEMPOREL

(30) Priority: 04.06.2007 EP 07109484
(43) Date of publication of application: 24.02.2010
(73) Proprietor: NXP B.V., 5656 AG Eindhoven (NL)
(72) Inventor: DORIS, Konstantinos, NL-5656 AG Eindhoven (NL)
(74) Representative: Hardingham, Christopher Mark
(86) International application number: PCT/IB2008/052076
(87) International publication number: WO 2008/149255

(56) References cited:
- US-A1- 2001 052 864
- US-A1- 2006 097 901

## Description

### FIELD OF THE INVENTION

The present invention relates to an error processing method in time interleaved operated signal processing devices, and a respective apparatus implementing the method. In particular, the invention relates to devices comprising a plurality of signal processing units having the same structure and at least one spatial error, and being adapted to subject an input signal from the signal input to predetermined signal processing, where the signal processing units are operated in a time interleaved schema.

### BACKGROUND OF THE INVENTION

The shrinking of transistor sizes and the corresponding difficulties imposed by technology in realizing high performance analog hardware in the traditional manner, where one block or one component provides for a certain function, have led to an apparent paradigm-shift that becomes more and more popular: the use of spatial domain, i.e. many identically designed components, and signal processing techniques that combine them to generate more processing capabilities and to achieve greater accuracy.

At least two general manifestations of this trend can be observed in open literature and leading IC products. The first one assumes the use of hardware that operates in parallel but with different scheduling and time mapping. This allows exploiting the spatial domain, i.e. more can be placed in the same silicon area than before. The scheduling and time mapping of this hardware is such that they operate in shifted moments in time: combined together the processing effect is multiplied for a given amount of time.

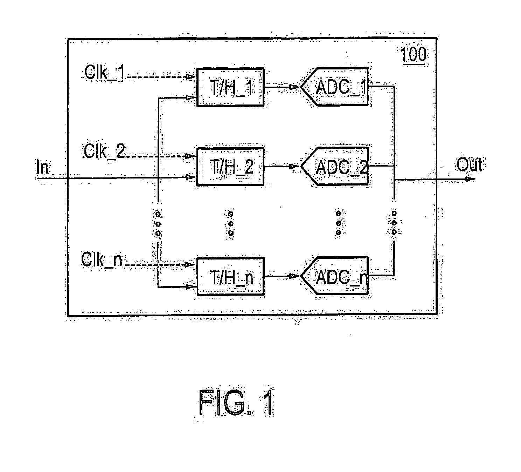

The architecture schematically illustrated in Fig. 1 is looked upon nowadays as a promising solution for wide-bandwidth high dynamic range sampling systems. In Fig. 1, a time interleaved Analog/Digital-Converter (A/D-converter, ADC) 100, as depicted in Fig. 1, employs several single ADC-units ADC_1, ADC_2, ..., ADC_n, which are arranged to be operated in parallel. The basic idea of time interleaving operation of the several ADC units is to use each individual ADC-units ADC_1, ADC_2, ..., ADC_n at different moments of time in order to extend the sampling rate of whole A/D-converter 100.

Further, in front of and/or inside each ADC_1, ADC_2, ..., ADC_n is located a respective track-and-hold-unit T/H_1, T/H_2, ... , T/H_n, which are controlled in a timely manner by a corresponding local clock signals Clk_1, Clk_2, ..., Clk_n. As a result an analog input signal supplied at the input In to the time interleaved A/D-converter 100 can be converted with a sampling rate which is n times faster as the sampling rate provided by one of the individual ADC-units, where the digital output signal is provided at the output terminal Out of the time interleaved A/D-converter 100.

A further example is US 5,933,033, which discloses a signal processing apparatus of a one-input/one-output configuration, where a switch circuit outputs an input signal to be processed in a switching manner to a signal-processing unit. The signal-processing unit comprises a plurality of signal processing units each having the same structure and subjecting an input signal to be processed to predetermined processing. Each of the signal processing units has an inherent signal processing error. A control means controls a switching operation of the switch means by use of a cyclic signal or a random signal such that switched output from the switch means is input to an arbitrary combination of the signal processing units. Further, an output from the arbitrary combination of the signal processing units is synthesized by synthesizing means with an integration circuit. As a result, the synthesizing means produces one output signal in which the inherent signal processing errors of the respective signal processing units is averaged.

Recently the use of spatial domain has received a second particular manifestation, observed in ADC's and digital-to-analog-converters (D/A-converters, DAC's), namely the use of redundancy in the form of many non-precise components that are combined in a smart way to realize a more precise component.

For instance, US 2001/0052864 A1 teaches adding of a redundant circuit to a plurality of electronic circuits and an having an interleaving operation among these circuits so as to control frequency-dependent spurious signals. Accordingly, when the operating frequency of each electronic circuit is f and when the operating frequency is to be Nf (where N is an integer of 2 or more), the number of electronic circuits used is chosen to be N+J, where J is a positive integer and called the number of redundancy. Since a redundant circuit is added, one electronic circuit can be selected among the plurality of the electronic circuits and is used for obtaining an output. While it is possible, for example, to use a fixed pattern with some complexity for the selection of such a circuit, it is preferable to select, in a pseudorandom manner, an electronic circuit that is to be used next for output among J+1 electronic circuits that are found by removing the circuits that were used for the present output through the output N-2 times before the present output from the N+J circuits.

One of the limitations of time interleaved A/D-converters is related to the unwanted differences between single ADC's as a result of systematic and random effects, e.g. being process and/or mismatch related. All those errors can be called spatially local errors because they are caused by the spatial variations of processing and other parameters. In other words, each identically designed single ADC or other related circuits exhibits a spatial behavior on chip. Of particular importance here are timing differences caused by systematic clock distribution path differences and random effects caused by mismatch in clock driving circuits and sampling switches. In principle, the random part is more difficult to cope with because of its statistical nature, which makes errors to vary significantly from chip to chip.

Measuring timing differences and re-aligning the timing edges has been proposed and used in practice in commercial applications of very expensive and power hungry systems, e.g. as described in K. Poulton, et.al. "A 20Gs/s 8b ADC with a 1 MB Memory in 0.18um CMOS", ISSCC Digest of Technical papers, pp. 318-320, 2003. The correction of timing errors, i.e. measurement and calibration of the individual clock sampling stages of the single ADC's, or other techniques that process the sampling errors digitally, such as blind estimation and equalization and other, receives at the moment substantial interest in open literature, mainly theoretical, as, for instance, in J. Elbomsson, et. al., "Blind Equalization of Time Errors in a Time Interleaved ADC System", IEEE Trans. On Signal Processing, vol. 53, no. 4, April 2005.

One of the critical implementation issues is the timing correction phase. The difficulty in realizing this phase is that the circuits used to correct the local clock signal timing have subsequent effects on the timing errors magnitude, and impair the steepness of the clock signal, with subsequent effects on the dynamics of the converter. This leads to the situation that it is often easier to avoid timing error correction and make efforts to achieve as good timing accuracy as possible by design, than trying to correct it. This, however, leads to fundamental timing accuracy versus power limitations that cannot be broken. Moreover, while it may be feasible to achieve precise timing by design when a few units are used it becomes extremely difficult to do so for many units, that is, when a high sampling rate is aimed.

In this connection it is noted that for a calibration, the timing error range that needs to be covered in a fixed number of discrete steps, which corresponds to the timing resolution, can be determined by the maximum timing error deviations between different slices/samples. Accordingly, the more and more units are used in a time interleaved manner to reach higher sampling rates, the larger their systematic (clock or manufacturing process related) timing errors become and at the same time, the smaller the timing error that is tolerated becomes. Thus, to cover large timing error differences one needs very high timing error resolutions, e.g. differences of 100 psec with 0.25 psec correction step needed to be implemented in K. Poulton, et. al. cited above.

United States patent application publication US 2006/097901 discloses an analog-to-digital convertor operable with staggered timing.

Accordingly, it is one object of the present invention to provide an apparatus and a method, which provides for reduction of the impact of the errors mentioned above. It is yet another object of the invention to provide an apparatus and a method which provides for reduced errors related to mismatch without use of correction hardware that would have influence on the edges of the sampling signals, e.g. local clocks.

### SUMMARY OF THE INVENTION

In a first aspect of the present invention a signal processing apparatus is presented that comprises: a signal input and a signal output; a plurality of signal processing units, wherein each signal processing unit has the same structure and at least one spatial error, each signal processing unit being connected to the signal input and being adapted to subject an input signal from the signal input to predetermined signal processing; selection means configured to select and form a predetermined number of operational groups from the plurality of signal processing units in accordance with a predetermined criterion; and control means for controlling the operational groups of the signal processing units to be active in a time interleaved schema, wherein an active operational group provides a respective processed input signal as an output signal to the signal output; wherein the plurality of signal processing units comprises more signal processing units as required to realize a predetermined time interleaving factor.

In a further aspect of the present invention a method for controlling a signal processing apparatus comprising a plurality of signal processing units, wherein each signal processing unit having the same structure and at least one spatial error, and being adapted to subject an input signal to predetermined signal processing, is presented as defined in claim 15.

In a first embodiment the selection means is configured to select and form at least one additional non-operational group comprised of signal processing units not to be used in operation of the apparatus. Accordingly, by having a multiplicity of signal processing units M, whereas in order to realize a time interleaving factor of N for the apparatus the number needs to be M>N. By having M-N more units as required redundancy is introduced into the system, which can be exploited as follows. After measuring the M individual spatial errors in question of all signal-processing units (where any known method available may be applied or used), the best N units out of the total M signal processing units can be selected and used in operation of the apparatus. In turn, the rest M-N units may belong to the at least one additional group and are simply not used. It is worth noting that "best" may receive various specific meanings, which is exemplified and explained in more detail herein below.

In a further development of the signal processing apparatus the selection means is further configured to substitute any of the operational groups by a respective one of the at least one non-operational groups according to a predetermined strategy. In other words, the apparatus is comprised of the plurality of signal processing units, which are grouped (or clustered) into a predetermined number of groups, wherein the total number of signal-processing units is used. Further, the predetermined number of groups may contain equal or less signal-processing units than the total available signal-processing units. A first number of groups are configured to implement the primary time interleaving process. The selection means are further configured to replace any of the first number of groups by a respective one of the residual non-operational groups according to a predetermined strategy, e.g. implemented in a respective control algorithm in the selection means for control thereof In other words, one certain group belonging to the predetermined number of operational groups is exchanged with or substituted by another one from the residual non-operational groups, while the time interleaving operation is still executed. By this way of operation of the signal-processing apparatus a spatial-temporal averaging process can be resembled where the errors left after the grouping of signal-processing units can further be compensated for in time by applying the principles of dynamic element matching. Therefore, any available time averaging method can be used for that purpose.

In another embodiment alternatively or additionally to the embodiments above each group of the predetermined number of groups is comprised of a respective second number of signal processing units. Accordingly, the respective signal processing units in each group of the predetermined number of operational groups is connected so as to be operated simultaneously. Further, each group further comprises analyzing means configured for a specific analyzing function, such as averaging means, median determination means or alike, which are configured to determine average or the median, respectively, of the outputs of the simultaneously operated signal processing units of the group in question. The resulting signal can then be provided to the signal output of the apparatus.

In this connection, it should be appreciated that in this embodiment or other described embodiments, it is not necessary that all signal processing units of each group are used for the analyzing function. That is, if each group contains, for example, five signal-processing units, one up to five units may be used in the analyzing algorithm performed by the analyzing means. Moreover, there can be groups where all of the signal-processing units are used, and other groups where only a few are used.

Accordingly, it is noted that it is not necessary that all K groups contain the same number of units out of the total N units. For example, for a total of 16 sampling units one can choose between K=4 groups of 4 units each, but also 4 groups comprised of 8, 4, 2, 2, or 5, 3, 4,4 signal-processing units. Alternatively, there can be 4 groups comprised of 1, 2, 4, and 4 signal-processing units and the rest of 5 signal-processing units are not used at all. These approaches may be efficient when, for example, some of the signal-processing units have errors close to the average of a distribution and require minor compensation, whereas other units with errors that are far way from the average error need combination of more signal-processing units for good compensation. In other words, when errors are compensated easily, resources are either not spent at all or they are used for the rest of the signal-processing units that require for better compensation.

Accordingly, if the multiplicity of signal processing units of the apparatus is assumed to comprise M units, the second number of units for each group to be K, and that each unit to be characterized by a inherent timing error µk. Further, if mTs is the ideal sampling moment, where µk is relatively small compared to the required sampling period Ts. Then, it can be shown mathematically that when µk are relatively small compared to Ts (which very well applies in most relevant practical cases) the average of K independent output signal samples <x(mT+ µk)> for an input signal waveform x(t) generated by K independent signal processing units of one group with timing errors µk is equal to the output signal produced by one signal processing unit with a timing error m0, which is equal to the average of those K timing errors µk, and which of course receives the same input signal. It is noted that <y> means the average of y. Similar to the above is the case when offset errors or gain errors are considered.

As it regards the predetermined criterion, it is preferably related to the at least one spatial error of the signal processing units or combinations of thereof, wherein a spatial error of the signal processing units may be at least one of a timing error, offset error, gain errors, and alike.

As it regards the predetermined criterion, which basically can be an optimization of a predetermined target function, wherein the inherent processing errors of the individual processing units are used as arguments.

In another embodiment, the predetermined criterion is optimization of a predetermined target function, and wherein relative amplitude errors in the output of the signal processing units are used as arguments.

In a certain embodiment, where each signal-processing unit includes at least a signal-sampling component, which may be, for instance, comprised of a T/H-ADC combination, another argument to be used can be one or more of the properties of the input signal being sampled, as influenced due to the spatial errors. For example, an input signal such as a sinusoid or alike is sampled, and then in the digital domain, by means of applicable digital post processing operations corresponding properties of the input signal, which may be phase, amplitude, offset, etc., can be determined and recorded.

For example, by means of a Fast Fourier Transformation (FFT) block or alike the amplitude and/or phase of the sampled sinusoidal input signal can be determined such that a vector representation of the sampled signal is digitally available. Once the vectors of all sampling components of the signal processing units, which convert the same input signal, are known, the afore-mentioned optimization of a target function can be made, where those vectors are used as arguments.

In a further development the predetermined criterion is optimization of a predetermined target function, wherein the target function is arranged to consider properties of the sampled and digitized input signal of the complete apparatus or of each or of some of the signal processing units. In this embodiment, the apparatus further comprises digital processing means or a digital processing unit, which is configured to determine properties of the sampled and digitized input signal of the complete apparatus or of each or of some of the signal processing units. The properties, which are derived from the sampled and digitized input signal of the complete apparatus or of each or of some of the signal processing units, reflect the influence of the individual spatial errors of each processing unit.

In yet another embodiment, the predetermined criterion is optimization of a predetermined target function, and wherein the arguments for the target function are relative differences of the respective spatial error or the digital vector representation of the sampled signal of the signal processing units.

Further, the optimization of the target function may be one of the following: minimizing the sum of the arguments; selecting those signal processing units having the smallest or largest arguments; selecting those signal processing units having arguments closest to the average of all arguments; selecting those signal processing units having arguments closest to the median of all arguments; selecting those signal processing units having arguments closest to a predetermined value or an user-selected value. This is, for instance, the case where a user or a respective system control unit, such as a processor, can externally set one of the arguments, for example the tolerance for which the average of K selected signal processing units for a group is accepted.

The signal processing units are in certain embodiments one of the following list: an analog-to-digital-converter, a digital-to-analog-converter, a track-and-hold-circuit, a comparator circuit, or combination of a track-and-hold-circuit and an analog-to-digital-converter.

Preferred embodiments of the invention are defined in the dependent claims of the independent claims. It shall be understood that the apparatus of claim 1 and the method of claim 15 have similar and/or identical preferred embodiments as defined in the dependent claims thereof.

It goes without saying that the different embodiments can be implemented by a selection algorithm, which can be digitally implemented, on-chip as well as off-chip in case of the apparatus being implemented as an integrated circuit. Accordingly, a selection algorithm may be provided with vital spatial error information, and may define the groups of signal processing units as well as which units will be used, and with which order. A clock logic and selection logic may simply implement the local clock signals (or other control signals) that are applied to the signal processing units.

In case of dealing with a multiplicity of spatial errors simultaneously, e.g. offset error, gain error, timing error and so on, the algorithm can have build-in smartness to select the best N units, where best means for example that the sum, or any other pre-selected function of errors is minimized.

It is worth noting that the concept of optimization of a "function of pre-selected errors" also applies to the above-mentioned embodiment where a post processing takes place to characterize the properties of the input signal being individually digitized by the used signal processing units in the digital domain. In other words, e.g. amplitude, phase, offset of an input signal, or alternatively differences in those properties can be used as arguments in a predetermined function for optimization. This total optimization process may be referred to as a multi-dimensional optimization.

Accordingly, the invention may be fully or partly be implemented as computer program comprising program code means for causing a computer to carry out the steps of the method when the computer program is carried out on a computer.

### BRIEF DESCRIPTION OF THE DRAWINGS

These and other aspects of the invention will be apparent from and elucidated with reference to the embodiment(s) described hereinafter. In the following drawings
Fig. 1 shows an example of time interleaved ADC;
Fig. 2 shows a conceptual scheme of an apparatus according to the present invention;
Fig. 3 shows one embodiment of an apparatus of the present invention, applied for groups of three ADC units (K=3); and
Fig. 4 illustrates methods for determining of the arguments useable in the embodiments of the time interleaved ADC's according to the invention.

The Figures are schematically drawn and not true to scale, and identical reference numerals in different Figures, if any, refer to corresponding elements. It will be clear for those skilled in the art that alternative but equivalent embodiments of the invention are possible without deviating from the true inventive concept, and that the scope of the invention is limited by the claims only.

### DETAILED DESCRIPTION OF EMBODIMENTS

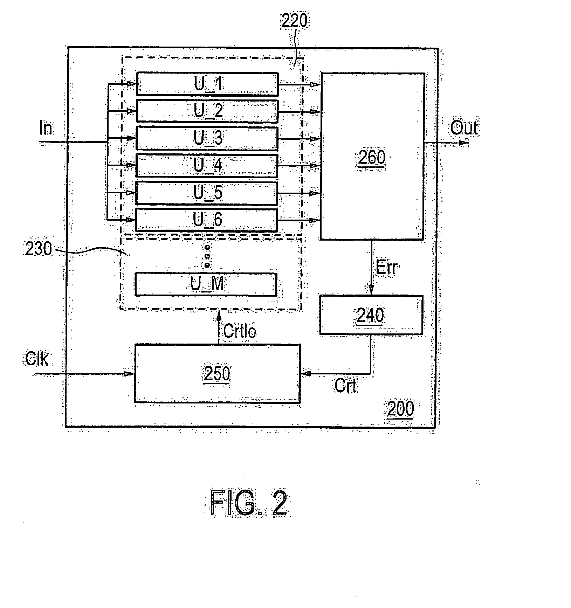

The basic concept of the invention is schematically illustrated in Fig. 2, which shows a conceptual scheme of an apparatus according to the present invention. It goes without saying that the Fig. 2 to 4 only focus on elements which are required for describing and understanding of the principles of the invention. Accordingly, for a person skilled in the art it should be clear that for a practical implementation the respective elements are to be realized by known hardware and software as well, which however is considered as standard design task.

In Fig. 2, a signal processing apparatus 200 consists of a multiplicity of signal processing units U_1, U_2, U_3, ... U_M, which are assumed for the purpose of illustration only to be sampling-units, in the embodiments described herein below. However, it should be noted that the sampling-units referred to in the detailed description are to be understood as signal processing units having the same structure and being connected to a common input signal, and being adapted to subject an input signal from the signal input to predetermined signal processing. Further, the sampling-units comprise at least one spatial error, which affects the overall performance of the apparatus. A sampling-unit may be comprised of a track-and-hold- unit (T/H unit) combined with an analog-to-digital-converter unit (ADC), or an ADC alone.

In this connection it is to be noted that the input signal may be provided to each signal-processing unit by means of replicating/copying circuits instead of being provided with one signal source only. Moreover, the potential differences of the errors included in the signal source replicas/copies can also be used in optimization functions, if needed. For example, the cited reference from K. Poulton at al uses a large amount of signal source replicas implemented on a Silicon-Germanium (SiGe) technology to be able to drive the 80 ADC units used as signal processing units. Those signal sources may have different phases, etc., which can be included in the optimization.

Further, the apparatus 200 comprises M sampling units U_1, U_2, U_3,... U_M, whereas to realize a time interleaving factor of N for the apparatus, the number of sampling units M needs to be M>N.

As mentioned above, by having M>N sampling units, redundancy of M-N is introduced into the system, which can be exploited. A first aspect of using the redundancy is to measure and evaluate M individual spatial errors, e.g. timing errors, of the corresponding sampling units U_1, U_2, U_3,... U_M and then, to select a first group 220 which comprises the best N out of the total of M units to be used in operation of the apparatus 200. The rest of M-N sampling units belong to a second or additional group 230, which is simply not used. It goes without saying that "best" may receive various specific meanings. Examples for how "best" can be understood will be discussed herein below. Moreover, it is noted that the concept is not limited to timing errors, but can be extended to any spatially error such as offset errors, gain errors, or combinations of them.

As mentioned above, the basic idea of the first aspect can be implemented by having selection means 240, which may be implemented as a selection algorithm implemented by digital logic hardware on- or off-chip. The selection means 240 needs to receive the relevant error information Err, e. g. information about the above mentioned timing error(s), in order to define which ones of the multiplicity of sampling-units U_1, U_2, U_3, ... U_M should be selected to be used. Further, it may also be defined with which order the selected sampling units of the group 220 will be used in operation of the apparatus 200. To that effect, the selection means is configured to perform the required selection in accordance with a predetermined selection criterion.

For example, a clock and selection logic 250 can simply implement a local clock signal or any another suitable control signal Crtlo which is applied to the sampling units U_1, U_2, U_3, ... U_M such that the respective sampling unit to be used is selected at the defined point in time and in the required order.

In this connection it is noted that it is also possible to consider a multiplicity of errors simultaneously, i.e. offset error, gain error, and timing error. For instance, the selection means 240 can have build-in smartness to select the best N sampling units, where best may mean that, for example, the sum (or any other pre-selected function) of errors as a target function is to be optimized, i.e. with regard to target function "sum of errors" optimizing would be achieved by minimizing the sum of errors. It is worth noting that the required clock and selection logic 250 is already present in time-interleaved ADC's to generate the corresponding local clock signals Clklo that defines which single ADC is activated at each time slot of the sampling operation.

In the following some further examples of the basic idea of the first aspect of the invention will be described in greater detail, where a first use of the proposed use of redundancy is to enable an outlier rejection option for an signal processing apparatus as illustrated in Fig. 2.

In practice, it are always a few slices, i.e. the output of some of the several time-interleaved signal processing units U_1, U_2, U_3, ... U_M, which show such extremely bad behavior that even if the rest are good, the total behavior of the signal processing apparatus 200 is substantially hampered. For example, out of a total of N=16 units, one or two may have extremely large timing errors, i.e. outliers. By using a redundancy of, for instance, 4 that means the signal processing apparatus 200 would have implemented a total of M=20 sampling units, simply the M-N=4 extremes can be disregarded, where "extremes" is to be understood as in the sense of being the worst in accordance to a predetermined criterion. Using only the group with the other N=16 sampling units in operation of the signal processing apparatus 200, the performance of the apparatus is improved significantly.

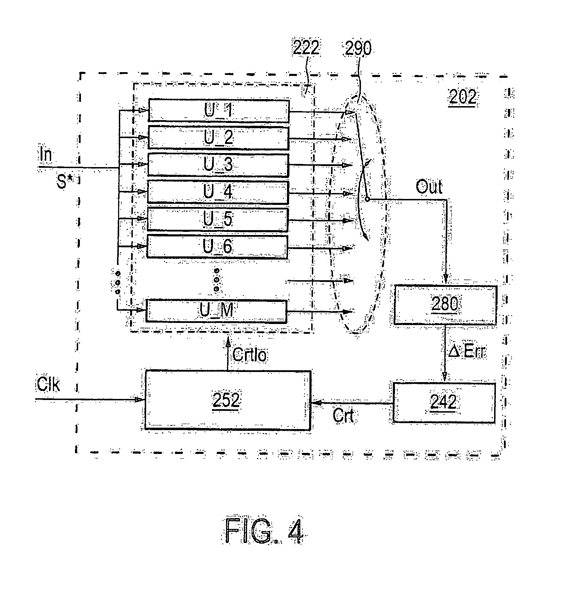

Another example for a possible selection criterion that can be used is the following. For determination of the required error information Err, a post-processing unit 260 for the time interleaved output streams of all sampling units U_1, U_2, U_3, ... U_M can be configured to have a calibration mode, which is activated for example when the apparatus 200 is enabled the first time. A more detailed explanation will be discussed in connection with Fig. 4. Then, once the interesting errors Err are known, the selection means 240 will select N out of the M sampling-units U_1, U_2, U_3, ... U_M in accordance with a predetermined criterion, e.g. a target function to be optimized can be used.

For instance, the selection means 240 may select those sampling units, which have the smallest or largest errors Err for the first group to be used, and the rest for the additional group which are simply not used.

Alternatively, the selection means 240 can select the sampling units corresponding to those errors Err that are closest to the average of the total of all, i.e. M, errors, after the average of the error distribution is evaluated. As it becomes clear from these examples, other possibilities exist as well.

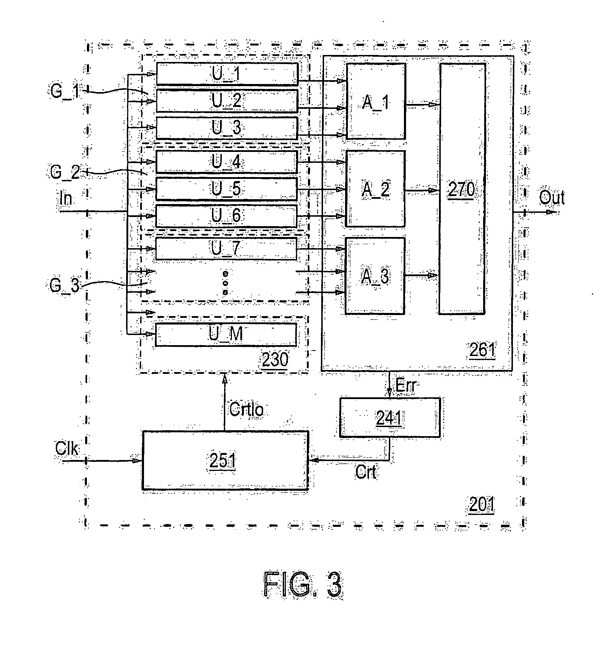

Now with respect to Fig. 3, which basically illustrates a further development of the signal processing apparatus 200 of Fig. 2. Reference sign 201 in Fig. 3 depicts the signal processing apparatus. Now, a more advanced selection strategy combines smart grouping and selection of sampling units. Basically, the described grouping does not necessitate redundancy as in the embodiment of Fig. 2, although it may favor significantly from it. In general, the approach according to the second aspect of the invention uses smartly selected sampling units U_1, U_2, U_3,... U_M and forming groups G_1, G_2, G_3 of sampling units, where the sampling units in the groups G_1, G_2, G_3 are operated.

For a better explanation, in Fig. 3 for the multiplicity M of sampling units U_1, U_2, U_3, ... U_M it is assumed for demonstration of the idea that required error information Err is available. The signal processing apparatus 201 comprises at least M sampling units, which are to grouped into at least N groups of sampling units and the groups are used in a time interleaved schema in operation of the apparatus 201. Further, each group consists of K sampling units that sample simultaneously. The output of each of the N groups is averaged by respective averaging means A_1, A_2, A_3 to reduce the effects of timing errors. A post-processing unit 270 for data-re-combination and/or demultiplexing the several outputs from the averaging means A_1, A_2, A_3 to the output Out of the apparatus 201. Furthermore, there may be also an addition group 230 according to the first aspect, in which additional group 230 are those sampling units grouped together which are identified as outliers which will not be used, i.e. discarded.

Each sampling unit U_1, U_2, U_3,... U_M can be characterized by its, for instance, timing error µ_k. When mTs depicts the ideal sampling moments, and µ_k is relatively small compared to the sampling period Ts, which is met in almost all practical applications. It can be shown mathematically that the average of K independent samples <x(mT+ µ_k)> (where <y> means the average of y) of the waveform x(t) generated by K independent sampling units with timing errors µ_k is equal to a sample produced by one sampling unit with a timing error µ_0, where µ_0 is equal to the average of the K timing errors <µ_k>.

With respect to Fig. 3, this means that the group G_1 of K=3 single sampling units U_1, U_2, U_3 with errors µ_k used simultaneously and with averaged output can provide the digital equivalent of those samples with much greater timing accuracy, since the accuracy is defined by the average of the K errors µ_k.

Although the arrangement according to the second aspect of the invention already brings improvement, a much greater improvement can be realized once the selection of those groups of K follows some smart rules, examples of which are discussed in the following.

In one embodiment, the N groups of K sampling units (where each sampling unit is afflicted by a respective µk error) are grouped intelligently such that each of the N groups, symbolized by G_n, where n being from 1 to N, of K sampling units achieves an average µ_n=<µ_k>, where k being from 1 to K, that is equal, or almost equal to the average of any other group.

Then, for example, the average errors between different groups G_n can be made substantially zero, or at least very small. As a consequence, samples taken as the average of the sampling units of each group G_n will have very small error. In other words, by using cleverly the combined sampling of several individual sampling units leads to a significant improvement of the overall sampling performance in terms of accuracy.

With respect to Fig. 3, for further illustration it is assumed that µ0 is the average of a total of 48 errors stemming from M=48 single sampling units U_1, U_2, U_3, ... U_48. Each sampling unit U_n receives its own local clock signal from the clock and selection logic 251, which defines when an enabled (e.g. clocked) sampling unit U_n samples. The error µ_0 can be digitally calculated with the information Err of the individual µ_k's. The total of 48 sampling units U_1, U_2,... U_48 are further grouped in N=16 groups G_1, G_2, ..., G_16 of K=3 sampling units, which again by way of example may be ADC-units. Accordingly, a time interleave factor of N=16 is realized.

The criterion for grouping of K=3 sampling units can be such that the average timing error of each group G_n is almost the same, or at least within a given bound or range. As a result, the samples taken by each of the 16 groups G_1, G_2, ...; G_16 will be almost the same, in other words, the effect is as if no timing errors existed in the first place.

In the embodiment shown in Fig. 3, the selection means 241 is configured to perform the grouping by sending respective control signals Crt to the clock and selection logic 251. The clock and selection logic 251 then forms the individual groups ("grouping"), for instance, by generating the same local control signals Crtlo for those sampling units belonging to a particular group G_1, G_2, G_3, ..., G_N. Moreover, the clock and selection logic 251 may also discard sampling units not to be used, e.g. an additional group 230 for outliers, simply by keeping them continuously off. It is worth noting that even though in Fig. 3 the individual groups G_n are formed by adjacent sampling units, e.g. U_n, U_n+1, U_n+2, it should be clear that this is only for the purpose of better illustration. Basically, each possible combination of K sampling units U_n for a particular group G_n can be formed by the clock and selection logic 251 and will reflect more likely the actual situation.

Both spatially deterministic local timing errors such as those caused by differences in clock interconnect lengths (and which are identified in the pre-fabrication phase), and spatially random methods can be addressed in this way. It has been found that the more systematic the error in question is, e.g. linear gradients caused by long and straight interconnect lines, the easier the grouping of units becomes.

Both aspects described above can be used separately, together, but also in combination with timing error calibration. For calibration, the timing error range that needs to be covered in a fixed number of discrete steps, which corresponds to the timing resolution, is determined by the maximum timing error deviations between different slices. The more and more units are interleaved to reach higher sampling rates, the larger their systematic (clock or process related) timing errors become and at the same time, the smaller the timing error that is tolerated becomes. Thus, to cover large timing error differences very high timing error resolutions are needed, e.g. differences of 100 psec with 0.25 psec correction step needed to be implemented, as described in *K. Poulton, et.al* cited above.

By the invention, using the proposed approaches, not only outliers can be eliminated, which significantly reduces the calibration range, but also the advantages of both approaches can be exploited simultaneously. That is to say, a basic coarse timing calibration system can correct large timing errors due to systematic interconnect differences, and an additional redundancy can be used to deal with the statistical effects.

Another simultaneous use of both approaches is to allow as many as K units to be calibrated, as many as the number of groups. Then, a grouping can take place where each of the K groups contains one of the calibrated units and K-1 non-calibrated ones (e.g. for K=3, there are two (2) non calibrated and one (1) calibrated unit). The objective of the grouping is to minimize the combined error as previously mentioned. Subsequently, fine-tuning can take place by calibrating the last unit such that the combined group has minimal or zero error.

As it regards the measurement of the inherent spatial errors of the signal processing units to be used in an time interleaved operation, there exist several known methods to measure the spatially local timing errors of systems such as time interleaved ADC's, clock distribution networks, and so on. Some of them can also be implemented on-chip.

In the context of the present invention has been found that an effective straightforward concept to characterize errors is firstly, to evaluate the relative differences of the errors in question. It has been found, that it is of relative small interest to identify the absolute measurement of spatial errors, such as timing errors, offset errors, gain errors to name some examples. In other words, if all errors are the same, then there is no error in the whole apparatus at all.

Further, it has been found that secondly, it is possible to characterize the different effects of the errors on the outputs of the signal processing units. That is to say, it is not necessary to measure, for example, timing errors or offset errors specifically in psec's or mVolts, respectively. Hence, the resulting error in, for instance, the amplitude outputs of the units are of more interest. Therefore, all processing can be realized in relative amplitude errors in the output of the signal processing units.

Under consideration of the two observations above, a known signal S* can be input to the plurality of sampling units U_1, U_2, ..., U_M arranged as illustrated in Fig. 4. Then, all digital outputs of all sampling units U_1, U_2, ..., U_M can be stored in a memory or storage 280. It will be understood that it is not essential for the here-disclosed solutions, how the calibration is performed in detail. For instance, by means of a demultiplexer 290 the individual output of each of the sampling units U_1, U_2, ..., U_M can be supplied in a timely controlled manner to the storage or memory 280, which may also be a buffer or register. Then, with these individual values available, the proposed differences from the average behavior can be calculated and supplied as the required absolute error information Err (as assumed in Fig. 2 and 3) or differential error information ΔErr (in Fig. 4) to the selection means 242. Next, the selection means 242 can perform the proposed selection process according to a predetermined criterion following the principles mentioned above in the context of the described embodiments, shown in Fig. 2 and 3.

It is noted that also error characterization methods may be used that do not require explicit storage of the digitized signals in memory. For example, an autocorrelation function of the signals being sampled by each signal-processing unit can be configured to provide information about related errors, but it does not require storage of the signal. In this particular case the autocorrelation calculation can be updated (added in fact) to the previous sum of errors. In other words, only the latter needs to be recorded to memory.

Alternatively, one particular output signal from one of the plurality of signal processing units U_1, U_2, ..., U_M, e.g. U_1 may be selected or defined as a nominal or reference value. Then, the differences of the other samples, i.e. the respective output of the other signal processing units U_2, U_3,..., U_M, from that reference value can be calculated. Based on these difference data, again, the selection procedure may be done as described above.

As a further alternative or additionally, a special input signal S* can be configured which is adapted to focus on measuring offset errors, gain errors or timing errors, or all of them together of the plurality of sampling units U_1, U_2, ..., U_M. For example, an input signal in form of a DC signal is able to determine the combined effect of gain errors and offset errors of the sampling units U_1, U_2, ..., U_M. Further, an input signal undergoing transition is able to determine timing errors. Furthermore, by using two different DC input signals and calculating the differences of the respective output signals of the sampling units U_1, U_2, ..., U_M is able to determine the gain errors. Alternatively, digital signal processors making operations such as Fast Fourier Transformation (FFT) or digital channel selection filtering can potentially provide information about the properties of the input signals being converted, e.g. amplitude, phase, frequency, offset, etc., individually by each signal processing unit such that the optimization procedure can be based on those properties (and/or their differences) and not the errors explicitly.

Hence, it will be appreciated that by consideration of these ways, no special measurement hardware is required that is not inherently available in the interesting sampling units such as in ADC, except from the signal source.

Now a further development of the invention will be explained in connection with Fig. 3. The signal processing apparatus 201 comprises M units, which are grouped (or clustered) into N = K + L groups, where the total M units are used, for instance, by smart grouping as described above. However, in contrast to Fig. 3, the N groups may contain equal or less signal-processing units than the total available M signal-processing units.

Now, the K groups are used for implementing a primary time interleaving process, as described in connection with the other embodiments. The L additional groups are used to replace any of the K groups according to a predetermined strategy (e.g. implemented in or as a respective control algorithm), which determines the exchange of a certain group belonging to the K operational groups with another from the L non-operational groups, while the time interleaving operation is executed.

For instance, the required replacing operation can be executed by the selection logic 251 (or alternatively any additional dedicated and respectively configured functionality). By this arrangement a spatial-temporal averaging process can be resembled, where the errors still left after the grouping step can be further compensated for by an averaging in time, e.g. by applying the principles of dynamic element matching. It is noted that any available time averaging method can be used in combination with this embodiment.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality. A single means or other unit may fulfill the functions of several items recited in the claims. The mere fact that certain measures are recited in mutually different dependent claims does not indicate that a combination of these measured cannot be used to advantage.

A computer program may be stored/distributed on a suitable medium, such as an optical storage medium or a solid-state medium supplied together with or as part of other hardware, but may also be distributed in other forms, such as via the Internet or other wired or wireless telecommunication systems.

Any reference signs in the claims should not be construed as limiting the scope.

## Claims

1. A signal processing apparatus (200) comprising:
- a signal input (In) and a signal output (Out);
- a plurality of signal processing units (U1, U2, ...U_M), wherein each signal processing unit has the same structure and at least one spatial error, each signal processing unit being connected to the signal input and being adapted to subject an input signal from the signal input to predetermined signal processing;
- selection means (240) configured to select and form a predetermined number of operational groups from the plurality of signal processing units in accordance with a predetermined criterion; and
- control means (250) for controlling the operational groups of the signal processing units to be active in a time interleaved schema, wherein an active operational group provides a respective processed input signal as an output signal to the signal output; wherein the plurality of signal processing units comprises more signal processing units as required to realize a predetermined time interleaving factor.

2. The apparatus according to claim 1, wherein the selection means is configured to select and form at least one additional non-operational group comprised of signal processing units not to be used in operation of the apparatus.

3. The apparatus according to claim 2, wherein the selection means is further configured to substitute any of the operational groups by a respective one of the at least one non-operational groups according to a predetermined strategy.

4. The apparatus according to one of the claims 1 to 3, wherein each group of the predetermined number of groups comprises a respective second number of signal processing units.

5. The apparatus according to one of the preceding claims, wherein respective signal processing units in each group of the predetermined number of groups are connected so as to be used simultaneously; wherein each group further comprises analyzing means configured to analyze the outputs of all or some selected units of the signal processing units of the respective group; and wherein the resulting signal of the analysis is provided to the signal output of the apparatus.

6. The apparatus according to claim 5, wherein analyzing the outputs of all or some selected units of the signal processing units of the respective group is deriving the average, the median, or a weighted average of the outputs of all or some selected units of the signal processing units.

7. The apparatus according to one of the preceding claims, wherein the predetermined criterion is related to the at least one spatial error of the signal processing units or combinations of thereof.

8. The apparatus according to claim 7, wherein a spatial error of the signal processing units is at least one of a timing error, offset error, gain errors, amplitude errors, phase errors, and alike.

9. The apparatus according to claim 7 or 8, wherein the predetermined criterion is optimization of a predetermined target function, and wherein the spatial processing errors are used as arguments.

10. The apparatus according to one of the claims 7 or 8, wherein the predetermined criterion is optimization of a predetermined target function, and wherein relative errors in the output of the signal processing units or the output of the apparatus are used as arguments.

11. The apparatus according to one of the claims 7 or 8, wherein the predetermined criterion is optimization of a predetermined target function,
wherein the target function considers properties of the sampled and digitized signal of the complete apparatus or of each individual signal processing unit, and
wherein the apparatus further comprises a digital processing unit which is configured to determine properties of the sampled and digitized signal of the complete apparatus or of each individual signal processing unit, which properties reflect the influence of the individual spatial errors of each processing unit.

12. The apparatus according to one of the claims 7 or 8, wherein the predetermined criterion is optimization of a predetermined target function, and wherein the argument for the target function are absolute or relative differences of the respective spatial error of the signal processing units or the output of the apparatus.

13. The apparatus according to one of the claims 9 to 12, wherein optimization of the target function is one of the following: minimizing the sum of the arguments; selecting those signal processing units having the smallest or largest arguments; selecting those signal processing units having arguments closest to one of the average of all arguments, the median of all arguments; a weighted average of all arguments; a predetermined value; a user-selected value.

14. The apparatus according to one of the preceding claims, wherein a signal-processing unit is one of the following list: an analog-to-digital-converter, a digital-to-analog-converter, a track-and-hold-circuit, a comparator, or combination of a track-and-hold-circuit and an analog-to-digital-converter.

15. A method for controlling a signal processing (200) apparatus comprising a plurality of signal processing units (U1, U2, ...U_M), wherein each signal processing unit has the same structure and at least one spatial error, and each signal processing unit is connected to a common signal input adapted to subject an input signal (In) to predetermined signal processing, the method comprising:
- selecting signal processing units from the plurality of signal processing units in accordance with a predetermined criterion;
- forming a first number of operational groups from the selected signal processing units, wherein each group comprises a respective second number of signal processing units; and
- controlling the groups of the signal processing units in a time interleaved schema such that an active group provides a respective processed input signal as an output signal (Out);
wherein the selecting and forming step comprises forming at least one additional non-operational group with signal processing units not used in operation of the apparatus.

16. The method according to claim 15, further comprising substituting any of the operational groups by a respective one of the at least one non-operational groups according to a predetermined strategy.

17. The method according to claims 15 or 16, further comprising controlling the predetermined number of groups in a time interleaved schema such that the signal processing apparatus achieves a processing speed corresponding to the processing speed of one signal processing unit multiplied with the predetermined number of used groups.

18. The method according to one of the preceding claims 15 to 17, further comprising simultaneously using the respective signal processing units of each group, and analyzing the outputs of all or some of the signal processing units of each group.

19. The method according to claim 18, wherein analyzing the outputs of all or some selected units of the signal processing units of the respective group comprises averaging, determining the median, or producing a weighted average of the outputs of all or some selected units of the signal processing units.

20. The method according to one of the preceding claims 15 to 19, wherein the selecting step further comprises optimizing a predetermined target function using the at least one spatial processing error of each signal processing unit as arguments.

21. The method according to claim 20, wherein the argument for the target function are relative or absolute errors of all or some of the output of the signal processing units or the output of the apparatus.

22. The method according to claim 21, wherein signal processing in a signal processing unit comprises:
- sampling and digitizing of the respective input signal; and
- optimizing the predetermined target function comprises determining properties of the sampled and digitized signal of the complete apparatus or of each individual signal processing unit, which properties reflect the influence of the individual spatial errors of each processing unit; and considering in the target function properties of the sampled and digitized signal of the complete apparatus or of each individual signal processing unit.

23. The method according to claim 20, wherein the argument for the target function are relative or absolute differences of the respective spatial error of the signal processing units or the output of the apparatus.

24. The method according to one of the preceding claims 19 to 23, wherein the step of optimizing the target function comprises at least one of the following steps:
minimizing the sum of a certain spatial error of all signal processing units; selecting those signal processing units having the smallest or largest spatial errors; selecting those signal processing units having spatial errors closest to the average of the total of spatial errors all signal processing units.

25. A computer program comprising program code means for causing a computer to carry out the steps of the method as claimed in one of the claims 15 to 24 when said computer program is carried out on a computer.

## Patentansprüche

1. Eine Signalverarbeitungsvorrichtung (200), aufweisend:
- einen Signaleingang (In) und einen Signalausgang (Out);
- eine Mehrzahl von Signalverarbeitungseinheiten (U1, U2, ...U_M), wobei jede Signalverarbeitungseinheit dieselbe Struktur und zumindest einen räumlichen Fehler aufweist, wobei jede Signalverarbeitungseinheit mit dem Signaleingang verbunden ist und geeignet ist, ein Eingangssignal von dem Signaleingang vorbestimmter Signalverarbeitung zu unterziehen;
- Auswahlmittel (240), die eingerichtet sind, eine vorbestimmte Anzahl von operativen Gruppen von der Mehrzahl von Signalverarbeitungseinheiten in Übereinstimmung mit einem vorbestimmten Kriterium auszuwählen und zu bilden; und
- Steuermittel (250), um zu steuern, dass die operativen Gruppen der Signalverarbeitungseinheiten in einem zeitverschachtelten Schema aktiv sind, wobei eine aktive operative Gruppe ein jeweiliges verarbeitetes Eingangssignal als ein Ausgangssignal zu dem Signalausgang bereitstellt;
wobei die Mehrzahl von Signalverarbeitungseinheiten mehr Signalverarbeitungseinheiten aufweist als benötigt, um einen vorbestimmten Zeitverschachtelungsfaktor zu realisieren.

2. Die Vorrichtung gemäß Anspruch 1, wobei die Auswahlmittel eingerichtet sind, zumindest eine zusätzliche nicht-operative Gruppe auszuwählen und zu bilden, die aus Signalverarbeitungseinheiten besteht, die nicht beim Betrieb der Vorrichtung verwendet werden.

3. Die Vorrichtung gemäß Anspruch 2, wobei die Auswahlmittel des Weiteren eingerichtet sind, irgendeine der operativen Gruppen durch eine jeweilige der zumindest einen nicht-operativen Gruppe gemäß einer vorbestimmten Strategie zu ersetzen.

4. Die Vorrichtung gemäß einem der Ansprüche 1 bis 3, wobei jede Gruppe der vorbestimmten Anzahl an Gruppen eine jeweilige zweite Anzahl an Signalverarbeitungseinheiten aufweist.

5. Die Vorrichtung gemäß einem der vorhergehenden Ansprüche, wobei jeweilige Signalverarbeitungseinheiten in jeder Gruppe der vorbestimmten Anzahl von Gruppen verbunden sind, um simultan verwendet zu werden, wobei jede Gruppe des Weiteren Analysemittel aufweist, die eingerichtet sind, die Ausgänge von allen oder manchen ausgewählten Einheiten der Signalverarbeitungseinheiten der jeweiligen Gruppe zu analysieren; und wobei das resultierende Signal der Analyse an den Signalausgang der Vorrichtung bereitgestellt wird.

6. Die Vorrichtung gemäß Anspruch 5, wobei Analysieren der Ausgänge von allen oder manchen ausgewählten Einheiten der Signalverarbeitungseinheiten der jeweiligen Gruppe Ableiten des Mittelwerts, des Median, oder eines gewichteten Mittelwerts der Ausgänge von allen oder manchen ausgewählten Einheiten der Signalverarbeitungseinheiten.

7. Die Vorrichtung gemäß einem der vorhergehenden Ansprüche, wobei das vorbestimmte Kriterium auf den zumindest einen räumlichen Fehler der Signalverarbeitungseinheiten oder Kombinationen davon bezogen ist.

8. Die Vorrichtung gemäß Anspruch 7, wobei ein räumlicher Fehler der Signalverarbeitungseinheiten zumindest einer von einem Fehler der zeitlichen Steuerung, einem Versatzfehler, Verstärkungsfehlern, Amplitudenfehler, Phasenfehlern, und ähnlichen.

9. Die Vorrichtung gemäß einem der Ansprüche 7 oder 8, wobei das vorbestimmte Kriterium Optimierung von einer vorbestimmten Zielfunktion ist, und wobei die räumlichen Verarbeitungsfehler als Argumente verwendet werden.

10. Die Vorrichtung gemäß einem der Ansprüche 7 oder 8, wobei das vorbestimmte Kriterium Optimierung von einer vorbestimmten Zielfunktion ist, und wobei relative Fehler in dem Ausgang der Signalverarbeitungseinheiten oder dem Ausgang der Vorrichtung als Argumente verwendet werden.

11. Die Vorrichtung gemäß einem der Ansprüche 7 oder 8, wobei das vorbestimmte Kriterium Optimierung von einer vorbestimmten Zielfunktion ist, wobei die Zielfunktion Eigenschaften des abgetasteten und digitalisierten Signals von der gesamten Vorrichtung oder von jeder individuellen Signalverarbeitungseinheit berücksichtigt, und
wobei die Vorrichtung des Weiteren eine digitale Verarbeitungseinheit aufweist, die eingerichtet ist, Eigenschaften des abgetasteten und digitalisierten Signals von der gesamten Vorrichtung oder von jeder individuellen Signalverarbeitungseinheit zu bestimmen, welche Eigenschaften den Einfluss des individuellen räumlichen Fehlers der Verarbeitungseinheit wiederspiegeln.

12. Die Vorrichtung gemäß einem der Ansprüche 7 oder 8, wobei das vorbestimmte Kriterium Optimierung einer vorbestimmten Zielfunktion ist, und wobei das Argument für die Zielfunktion absolute oder relative Differenzen von dem jeweiligen räumlichen Fehler von den Signalverarbeitungseinheiten oder von dem Ausgang der Vorrichtung sind.

13. Die Vorrichtung gemäß einem der Ansprüche 9 bis 12, wobei Optimierung der Zielfunktion eines der folgenden ist: Minimieren der Summe der Argumente; Auswählen derjenigen Signalverarbeitungseinheiten, die die kleinsten oder größten Argumente aufweisen; Auswählen derjenigen Signalverarbeitungseinheiten, die Argumente aufweisen, die am nächsten sind zu einem von dem Mittelwert von allen Argumenten, dem Median von allen Argumente; einem gewichteten Mittelwert von allen Argumente; einem vorbestimmten Wert; einem benutzerausgewählten Wert.

14. Die Vorrichtung gemäß einem der vorhergehenden Ansprüche, wobei eine Signalverarbeitungseinheit eine aus der folgenden Liste ist: ein Analog-zu-Digital-Wandler, ein Digital-zu-Analog-Wandler, eine Nachverfolgungs-Halte-Schaltung, ein Vergleicher, oder eine Kombination von einer Nachverfolgungs-Halte-Schaltung und einem Analog-zu-Digital-Wandler.

15. Ein Verfahren zum Steuern einer Signalverarbeitungsvorrichtung (200), die eine Mehrzahl von Signalverarbeitungseinheiten (U1, U2, ...U_M) aufweist, wobei jede Signalverarbeitungseinheit dieselbe Struktur und zumindest einen räumlichen Fehler aufweist, und wobei jede Signalverarbeitungseinheit mit einem gemeinsamen Signaleingang verbunden ist, der geeignet ist, ein Eingangssignal (In) vorbestimmter Signalverarbeitung zu unterziehen, wobei das Verfahren aufweist:
- Auswählen von Signalverarbeitungseinheiten aus der Mehrzahl von Signalverarbeitungseinheiten in Übereinstimmung mit einem vorbestimmten Kriterium;
- Bilden einer ersten Anzahl von operativen Gruppen aus den ausgewählten Signalverarbeitungseinheiten, wobei jede Gruppe eine jeweilige zweite Anzahl von Signalverarbeitungseinheiten aufweist; und
- Steuern der Gruppen der Signalverarbeitungseinheiten in einem zeitverschachtelten Schema, sodass eine aktive Gruppe ein jeweiliges verarbeitetes Eingangssignal als ein Ausgangssignal (Out) bereitstellt;
wobei der Auswahl- und Bildungsschritt Bilden von zumindest einer zusätzlichen nicht-operativen mit Signalverarbeitungseinheiten, die nicht beim Betrieb der Vorrichtung verwendet werden, aufweist.

16. Das Verfahren gemäß Anspruch 15, des Weiteren aufweisend Ersetzen irgendeiner der operativen Gruppen durch eine jeweilige der zumindest einen nicht-operativen Gruppe gemäß einer vorbestimmten Strategie.

17. Das Verfahren gemäß Anspruch 15 oder 16, des Weiteren aufweisend Steuern der vorbestimmten Anzahl von Gruppen in einem zeitverschachtelten Schema, sodass die Signalverarbeitungsvorrichtung eine Verarbeitungsgeschwindigkeit erreicht, die der Verarbeitungsgeschwindigkeit von einer Signalverarbeitungseinheit multipliziert mit der vorbestimmten Anzahl der verwendeten Gruppen entspricht.

18. Das Verfahren gemäß einem der vorhergehenden Ansprüche 15 bis 17, des Weiteren aufweisend simultanes Verwenden der jeweiligen Signalverarbeitungseinheiten von jeder Gruppe, und Analysieren der Ausgänge von allen oder manchen der Signalverarbeitungseinheiten von jeder Gruppe.

19. Das Verfahren gemäß Anspruch 18, wobei Analysieren der Ausgänge von allen oder manchen ausgewählten Einheiten der Signalverarbeitungseinheiten der jeweiligen Gruppe Mitteln, Bestimmen des Median, oder Erzeugen eines gewichteten Mittelwerts der Ausgänge von allen oder manchen ausgewählten Einheiten der Signalverarbeitungseinheiten aufweist.

20. Das Verfahren gemäß einem der vorhergehenden Ansprüche 15 bis 19, wobei der Auswahlschritt des Weiteren Optimieren von einer vorbestimmten Zielfunktion aufweist, wobei der zumindest eine räumliche Verarbeitungsfehler von jeder Signalverarbeitungseinheit als Argumente verwendet wird.

21. Das Verfahren gemäß Anspruch 20, wobei das Argument für die Zielfunktion relative oder absolute Fehler von allen oder manchen des Ausgangs der Signalverarbeitungseinheiten oder des Ausgangs der Vorrichtung sind.

22. Das Verfahren gemäß Anspruch 21, wobei Signalverarbeitung in einer Signalverarbeitungseinheit aufweist:
- Abtasten und Digitalisieren des jeweiligen Eingangssignals; und
- wobei Optimieren der vorbestimmten Zielfunktion Bestimmen von Eigenschaften des abgetasteten und digitalisierten Signals von der gesamten Vorrichtung oder von jeder individuellen Signalverarbeitungseinheit aufweist, welche Eigenschaften den Einfluss des individuellen räumlichen Fehlers von jeder Verarbeitungseinheit wiederspiegeln, und Berücksichtigen in der Zielfunktion von Eigenschaften des abgetasteten und digitalisierten Signals von der gesamten Vorrichtung oder von jeder individuellen Signalverarbeitungseinheit.

23. Das Verfahren gemäß Anspruch 20, wobei das Argument für die Zielfunktion relative oder absolute Differenzen von dem jeweiligen räumlichen Fehler von den Signalverarbeitungseinheiten oder dem Ausgang der Vorrichtung sind.

24. Das Verfahren gemäß einem der vorhergehenden Ansprüche 19 bis 23, wobei der Schritt des Optimierens der Zielfunktion zumindest einen der folgenden Schritte aufweist:
Minimieren der Summe eines gewissen räumlichen Fehlers von allen
Signalverarbeitungseinheiten; Auswählen derjenigen Signalverarbeitungseinheiten, die die kleinsten oder größten räumlichen Fehler aufweisen; Auswählen derjenigen Signalverarbeitungseinheiten, die räumliche Fehler aufweisen, die am nächsten zu dem Mittelwert von der Gesamtsumme von allen räumlichen Fehlern aller Signalverarbeitungseinheiten.

25. Ein Computerprogramm, das Programmcodemittel aufweist, um einen Computer zu veranlassen, die Schritte des Verfahrens gemäß einem der Ansprüche 15 bis 24 auszuführen, wenn das Computerprogramm auf einem Computer ausgeführt wird.

## Revendications

1. Appareil de traitement du signal (200) comprenant :
- une entrée de signal (In) et une sortie de signal (Out) ;
- une pluralité d'unités de traitement du signal (U1, U2, ... U_M), dans lequel chaque unité de traitement du signal a la même structure et au moins une erreur spatiale, chaque unité de traitement du signal étant raccordée à l'entrée de signal et étant agencée de manière à soumettre un signal d'entrée de l'entrée de signal à un traitement de signal prédéterminé ;
- des moyens de sélection (240) configurés de manière à sélectionner et à former un nombre prédéterminé de groupes opérationnels à partir de la pluralité d'unités de traitement du signal en fonction d'un critère prédéterminé ; et
- des moyens de commande (250) pour commander les groupes opérationnels d'unités de traitement du signal pour qu'elles soient actives d'une manière entrelacée dans le temps, dans lequel un groupe opérationnel actif fournit un signal d'entrée traité correspondant comme signal de sortie à la sortie de signal ; dans lequel la pluralité d'unités de traitement du signal comporte plus d'unités de traitement du signal qu'il n'est nécessaire pour réaliser un facteur d'entrelacement dans le temps prédéterminé.

2. Appareil selon la revendication 1, dans lequel les moyens de sélection sont configurés de manière à sélectionner et à former au moins un groupe supplémentaire non-opérationnel constitué d'unités de traitement du signal qui ne sont pas utilisées dans le fonctionnement de l'appareil.

3. Appareil selon la revendication 2, dans lequel les moyens de sélection sont en outre configurés de manière à remplacer l'un quelconque des groupes opérationnels par un groupe correspondant parmi les groupes non-opérationnels au nombre de un au moins selon une stratégie prédéfinie.

4. Appareil selon l'une des revendications 1 à 3, dans lequel chaque groupe parmi le nombre prédéfini de groupes comporte un deuxième nombre respectif d'unités de traitement du signal.

5. Appareil selon l'une quelconque des revendications précédentes, dans lequel des unités de traitement du signal respectives dans chaque groupe du nombre prédéterminé de groupes sont raccordées de manière à être utilisées simultanément ; dans lequel chaque groupe comporte en outre des moyens d'analyse configurés de manière à analyser les sorties de toutes les unités parmi les unités de traitement du signal du groupe correspondant ou de certaines unités choisies dans celui-ci ; et dans lequel le signal résultant de l'analyse est fourni au signal de sortie de l'appareil.

6. Appareil selon la revendication 5, dans lequel l'analyse des sorties de toutes les unités parmi les unités de traitement du signal du groupe correspondant ou de certaines unités choisies dans celui-ci consiste à dériver la moyenne, la médiane ou une moyenne pondérée des sorties de toutes les unités parmi les unités de traitement du signal du groupe correspondant ou de certaines unités choisies dans celui-ci.

7. Appareil selon l'une quelconque des revendications précédentes, dans lequel le critère prédéterminé a trait à au moins une erreur spatiale des unités de traitement du signal ou d'une combinaison de celles-ci.

8. Appareil selon la revendication 7, dans lequel une erreur spatiale des unités de traitement du signal est au moins une erreur parmi les erreurs de synchronisation, les erreurs de décalage, les erreurs de gain, les erreurs d'amplitude, les erreurs de phase et erreurs similaires.

9. Appareil selon les revendications 7 ou 8, dans lequel le critère prédéterminé consiste à optimiser une fonction cible prédéterminée, et dans lequel les erreurs spatiales de traitement sont utilisées comme arguments.

10. Appareil selon l'une des revendications 7 ou 8, dans lequel le critère prédéterminé consiste à optimiser une fonction cible prédéterminée, et dans lequel des erreurs relatives dans la sortie des unités de traitement du signal ou la sortie de l'appareil sont utilises comme arguments.

11. Appareil selon l'une des revendications 7 ou 8, dans lequel le critère prédéterminé consiste à optimiser une fonction cible prédéterminée, dans lequel la fonction cible considère des propriétés du signal échantillonné et numérisé de l'appareil complet ou de chaque unité de traitement du signal particulière, et dans lequel l'appareil comporte en outre une unité de traitement numérique qui est configurée de manière à déterminer des propriétés du signal échantillonné et numérisé de l'appareil complet ou de chaque unité de traitement du signal particulière, lesquelles propriétés reflètent l'influence des erreurs spatiales particulières de chaque unité de traitement.

12. Appareil selon l'une des revendications 7 ou 8, dans lequel le critère prédéterminé consiste à optimiser une fonction cible prédéterminée, et dans lequel les arguments de la fonction cible sont des différences absolues ou relatives des erreurs spatiales respectives des unités de traitement du signal ou de la sortie de l'appareil.

13. Appareil selon l'une des revendications 9 à 12, dans lequel l'optimisation de la fonction cible est l'une des suivantes : réduction de la somme des arguments ; sélection des unités de traitement du signal ayant les plus petits ou les plus grands arguments ; sélection des unités de traitement du signal ayant des arguments les plus proches d'une valeur parmi la moyenne de tous les arguments, la médiane de tous les arguments ; une moyenne pondérée de tous les arguments ; une valeur prédéterminée et une valeur choisie par l'utilisateur.

14. Appareil selon l'une des revendications précédentes dans lequel une unité de traitement du signal est un élément parmi la liste suivante : convertisseur analogique-numérique, convertisseur numérique-analogique, circuit échantillonneur-bloqueur, comparateur ou combinaison d'un circuit échantillonneur-bloqueur et d'un convertisseur analogique-numérique.

15. Procédé de commande d'un appareil de traitement du signal (200) comprenant une pluralité d'unités de traitement du signal (U1, U2, ... U M), dans lequel chaque unité de traitement du signal a la même structure et au moins une erreur spatiale, et dans lequel chaque unité de traitement du signal est raccordée à une entrée de signal commune et agencée de manière à soumettre un signal d'entrée (In) à un traitement de signal prédéterminé, le procédé comprenant :
- la sélection d'unités de traitement du signal à partir de la pluralité d'unités de traitement du signal en fonction d'un critère prédéterminé ;
- la formation d'un premier nombre de groupes opérationnels à partir des unités de traitement du signal sélectionnées, dans lequel chaque groupe comporte un deuxième nombre correspondant d'unités de traitement du signal ; et
- la commande des groupes d'unités de traitement du signal d'une manière entrelacée dans le temps, de telle sorte qu'un groupe actif fournit un signal d'entrée traité correspondant comme signal de sortie (Out) ;
dans lequel l'étape de sélection et de formation comporte la formation d'au moins un groupe non-opérationnel supplémentaire avec des unités de traitement du signal qui ne sont pas utilisées dans le fonctionnement de l'appareil.

16. Procédé selon la revendication 15, comprenant en outre le remplacement d'un quelconque des groupes opérationnels par un groupe correspondant parmi les groupes non-opérationnels au nombre de un au moins selon une stratégie prédéfinie.

17. Procédé selon les revendications 15 ou 16, comprenant en outre la commande du nombre prédéterminé de groupe d'une manière entrelacée dans le temps, de telle sorte que l'appareil de traitement du signal atteigne une vitesse de traitement correspondant à la vitesse de traitement d'une unité de traitement du signal multipliée par le nombre prédéterminé de groupes utilisés.

18. Procédé selon l'une des revendications précédentes 15 à 17, comprenant en outre l'utilisation simultanée d'unités de traitement du signal respectives de chaque groupe, et l'analyse des sorties de toutes les unités parmi les unités de traitement du signal de chaque groupe ou de certaines unités de celui-ci.

19. Procédé selon la revendication 18, dans lequel l'analyse des sorties de toutes les unités parmi les unités de traitement du signal du groupe correspondant ou de certaines unités choisies dans celui-ci consiste à dériver la moyenne, la médiane ou à produire une moyenne pondérée des sorties de toutes les unités parmi les unités de traitement du signal ou de certaines unités choisies dans celui-ci.

20. Procédé selon l'une des revendications précédentes 15 à 19, dans lequel l'étape de sélection comporte en outre l'optimisation d'une fonction cible prédéterminée utilisant comme arguments au moins une erreur spatiale de traitement de chaque unité de traitement du signal.

21. Procédé selon la revendication 20, dans lequel les arguments pour la fonction cible sont des erreurs absolues ou relatives de tout ou partie de la sortie des unités de traitement du signal ou de la sortie de l'appareil.

22. Procédé selon la revendication 21, dans lequel le traitement du signal dans une unité de traitement du signal comporte :
- l'échantillonnage et la numérisation du signal d'entrée correspondant ; et
- l'optimisation de la fonction cible prédéterminée comprenant la détermination de propriétés du signal échantillonné et numérisé de l'appareil complet ou de chaque unité de traitement du signal particulière, lesquelles propriétés reflètent l'influence des erreurs spatiales particulières de chaque unité de traitement ; et prise en considération, dans la fonction cible, de propriétés du signal échantillonné et numérisé de l'appareil complet ou de chaque unité de traitement du signal particulière.

23. Procédé selon la revendication 20, dans lequel les arguments de la fonction cible sont des différences relatives ou absolues des erreurs spatiales respectives des unités de traitement du signal ou de la sortie de l'appareil.

24. Procédé selon l'une des revendications précédentes 19 à 23, dans lequel l'étape d'optimisation de la fonction cible comporte l'une au moins des étapes suivantes : minimisation de la somme d'une certaine erreur spatiale de toutes les unités de traitement du signal ; sélection des unités de traitement du signal ayant les plus petites ou les plus grandes erreurs spatiales ; sélection des unités de traitement du signal ayant des erreurs spatiales les plus proches de la moyenne du total des erreurs spatiales de toutes les unités de traitement du signal.

25. Programme informatique comprenant des moyens de code informatique conduisant un ordinateur à effectuer les étapes du procédé tel que revendiqué dans l'une des revendications 15 à 24, lorsque ledit programme informatique est exécuté dans un ordinateur.
